# EUROPEAN PATENT APPLICATION

(11) **EP 4 285 761 A1**
(43) Date of publication of application: **06.12.2023**
(21) Application number: 21925149.3
(22) Date of filing: 09.02.2021
(51) Int. Cl.: A24F 40/50

(54) **ELECTRONIC ATOMIZING APPARATUS AND MICROWAVE CONTROL METHOD THEREFOR**

(71) Applicant: Shenzhen Smoore Technology Limited, Shenzhen Guangdong 518102 (CN)
(72) Inventor: DU, Jing, Shenzhen, Guangdong 518102 (CN); XIONG, Yuming, Shenzhen, Guangdong 518102 (CN); BU, Guihua, Shenzhen, Guangdong 518102 (CN)
(74) Representative: Westphal, Mussgnug & Partner, Patentanwälte mbB
(86) International application number: PCT/CN2021/076222
(87) International publication number: WO 2022/170468

(57) **Abstract**

The present invention relates to an electronic vaporization device and a method for controlling microwave thereof. The electronic vaporization device includes: a vaporization cavity configured to accommodate an aerosol-forming substrate; a microwave generating circuit configured to generate a microwave according to a preset-microwave-frequency; a microwave transmitting antenna configured to transmit the microwave; a feedback acquisition circuit configured to acquire a feedback signal corresponding to the microwave of the preset-microwave-frequency that is transmitted by the microwave transmitting antenna; and a microwave control circuit connected to the microwave generating circuit and the feedback acquisition circuit respectively, and configured to determine the preset-microwave-frequency. control the microwave generating circuit to generate the microwave according to the preset-microwave-frequency, and select a microwave-transmitting-frequency according to the feedback signal to maintain or modify the preset-microwave-frequency. The present invention uses the microwave to directly heat the aerosol-forming substrate, and adjusts the microwave-transmitting-frequency through sweeping, so as to improve the heating efficiency and extend the service life of the device.

## Description

### FIELD

The present invention relates to the field of aerosol-generating apparatuses, and more specifically, to an electronic vaporization device using microwave for heating and a method for controlling microwave thereof.

### BACKGROUND

The existing aerosol-generating apparatuses use an electric current to heat a heating plate. After the heating plate is heated, an aerosol-forming substrate is directly heated, thereby producing an aerosol. In this heating method, the heating plate and the aerosol-forming substrate are in direct contact. During the high-temperature vaporization process, the aerosol generates residues on the heating plate, which is difficult to clean. Long-term accumulation affects the heating efficiency of the heating plate, so that the service life of the aerosol-generating apparatuses is reduced, and user experience is poor.

### SUMMARY

### Technical Problems

The technical problem to be resolved by the present invention is to provide an electronic vaporization device, and a method for controlling microwave thereof for the foregoing defects in the related art.

### Technical Solutions

A technical solution adopted by the present invention to resolve the technical problem thereof is to provide an electronic vaporization device for heating and vaporizing an aerosol-forming substrate, including:
a vaporization cavity configured to accommodate an aerosol-forming substrate;
a microwave generating circuit configured to generate a microwave according to a preset-microwave-frequency;
a microwave transmitting antenna connected to the microwave generating circuit, and configured to sweep and transmit the microwave within a preset-microwave-frequency-range and transmit the microwave to the vaporization cavity to heat the aerosol-forming substrate, where
a feedback acquisition circuit configured to acquire a feedback signal corresponding to the microwave of the preset-microwave-frequency that is transmitted by the microwave transmitting antenna; and
a microwave control circuit connected to the microwave generating circuit and the feedback acquisition circuit respectively, where the microwave control circuit is configured to determine the preset-microwave-frequency and control the microwave generating circuit to generate the microwave according to the preset-microwave-frequency, and the microwave control circuit is configured to select a microwave-transmitting-frequency according to the feedback signal to maintain or modify the preset-microwave-frequency.

Further, in the electronic vaporization device in the present invention, the feedback signal is a feedback current value, and the feedback acquisition circuit is a current acquisition circuit; or
the feedback signal is a feedback voltage value, and the feedback acquisition circuit is a voltage acquisition circuit; or
the feedback signal is a feedback capacitance value, and the feedback acquisition circuit is a capacitance acquisition circuit; or
the feedback signal is a feedback temperature value, and the feedback acquisition circuit is a temperature acquisition circuit.

Further, in the electronic vaporization device in the present invention, the feedback signal is a reverse microwave power, and the feedback acquisition circuit is a microwave reverse power detector.

Further, in the electronic vaporization device in the present invention, the microwave reverse power detector is configured to detect a reverse microwave power received by the microwave transmitting antenna.

Further, the electronic vaporization device in the present invention further includes a microwave forward power detector connected to the microwave control circuit and configured to acquire a microwave transmitting power.

Further, the electronic vaporization device in the present invention further includes a power amplifier, where an output end of the microwave generating circuit is connected to a first input end of the power amplifier, and an output end of the power amplifier is connected to the microwave transmitting antenna; and the microwave control circuit is connected to the power amplifier and configured to adjust the power amplifier according to the feedback signal.

Further, the electronic vaporization device in the present invention further includes a power regulator, where the microwave control circuit is connected to an input end of the power regulator, an output end of the power regulator is connected to a second input end of a power amplifier, and the microwave control circuit is configured to adjust the power regulator according to the feedback signal.

Further, the present invention further provides a heat-not-burn electronic vaporization device, including:
a vaporization cavity configured to accommodate an aerosol-forming substrate;
a circuit board including a microwave generating circuit, a feedback acquisition circuit, and a microwave control circuit, where the microwave control circuit is connected to the microwave generating circuit and the feedback acquisition circuit respectively, and the microwave generating circuit is configured to generate a microwave according to a preset-microwave-frequency;
a microwave transmitting antenna connected to the microwave generating circuit, and configured to sweep and transmit the microwave within a preset-microwave-frequency-range and transmit the microwave to the vaporization cavity to heat the aerosol-forming substrate, where
the feedback acquisition circuit acquires a feedback signal corresponding to the microwave of the preset-microwave-frequency that is transmitted by the microwave transmitting antenna; and the microwave control circuit is configured to determine the preset-microwave-frequency and control the microwave generating circuit to generate the microwave according to the preset-microwave-frequency, and the microwave control circuit selects a microwave-transmitting-frequency according to the feedback signal to maintain or modify the preset-microwave-frequency.

Further, in the heat-not-burn electronic vaporization device in the present invention, the feedback signal is a feedback current value, and the feedback acquisition circuit is a current acquisition circuit; or
the feedback signal is a feedback voltage value, and the feedback acquisition circuit is a voltage acquisition circuit; or
the feedback signal is a feedback capacitance value, and the feedback acquisition circuit is a capacitance acquisition circuit; or
the feedback signal is a feedback temperature value, and the feedback acquisition circuit is a temperature acquisition circuit.

Further, in the heat-not-burn electronic vaporization device in the present invention, the feedback signal is a reverse microwave power, and the feedback acquisition circuit is a microwave reverse power detector.

Further, in the heat-not-burn electronic vaporization device in the present invention, the microwave reverse power detector is configured to detect a reverse microwave power received by the microwave transmitting antenna.

Further, the heat-not-burn electronic vaporization device in the present invention further includes a microwave forward power detector connected to the microwave control circuit and configured to acquire a microwave transmitting power.

Further, the heat-not-burn electronic vaporization device in the present invention further includes a power amplifier, where an output end of the microwave generating circuit is connected to a first input end of the power amplifier, and an output end of the power amplifier is connected to the microwave transmitting antenna; and the microwave control circuit is connected to the power amplifier, and the microwave control circuit is configured to adjust the power amplifier according to the feedback signal.

Further, the heat-not-burn electronic vaporization device in the present invention further includes a power regulator, where the microwave control circuit is connected to an input end of the power regulator, an output end of the power regulator is connected to a second input end of a power amplifier, and the microwave control circuit is configured to adjust the power regulator according to the feedback signal.

Further, the heat-not-burn electronic vaporization device in the present invention further includes a microwave aggregation apparatus, where the microwave transmitting antenna is located in the microwave aggregation apparatus, and the microwave aggregation apparatus is configured to aggregate at least a part of the microwave transmitted by the microwave transmitting antenna to the vaporization cavity.

Further, in the heat-not-burn electronic vaporization device in the present invention, an inner layer of the microwave aggregation apparatus is a microwave reflective layer.

Further, in the heat-not-burn electronic vaporization device in the present invention, an outer layer of the microwave aggregation apparatus is a microwave shielding layer.

In addition, the present invention further provides a method for controlling microwave applicable to the foregoing electronic vaporization device, including:
S1: controlling, by a microwave control circuit, a microwave generating circuit to generate a microwave for a microwave transmitting antenna to sweep and transmit the microwave with a preset-microwave-frequency-range, where the microwave is used to heat an aerosol-forming substrate in a vaporization cavity;
S2: acquiring, by a feedback acquisition circuit, a feedback signal corresponding to the microwave, and transmitting the feedback signal to the microwave control circuit; and
S3: selecting, after the microwave is swept and transmitted, by the microwave control circuit, a microwave-transmitting-frequency according to the feedback signal.

Further, in the method for controlling microwave in the present invention, the selecting, by the microwave control circuit, a microwave-transmitting-frequency according to the feedback signal in step S3 includes: selecting, by the microwave control circuit, the microwave-transmitting-frequency and a microwave transmitting power according to the feedback signal.

Further, in the method for controlling microwave in the present invention, the feedback signal in step S2 is a reverse microwave power; and
the selecting, by the microwave control circuit, a microwave-transmitting-frequency according to the feedback signal in step S3 includes: selecting, by the microwave control circuit, the microwave-transmitting-frequency corresponding to a minimum value of the reverse microwave power.

Further, in the method for controlling microwave in the present invention, before step S1, the method further including:
S101: receiving, by the microwave control circuit, a microwave frequency selection instruction; or
S102: receiving, by the microwave control circuit, an aerosol-forming substrate installation completion instruction; or
S103: receiving, by the microwave control circuit, an inhalation instruction; or
S104: presetting, by the microwave control circuit, an inhalation time every interval.

### Beneficial Effects:

By implementing the electronic vaporization device and the method for controlling microwave thereof of the present invention, the following beneficial effects may be achieved: The present invention uses the microwave to directly heat the aerosol-forming substrate, and adjusts the microwave-transmitting-frequency through sweeping, so as to improve the heating efficiency and extend the service life of the device.

### BRIEF DESCRIPTION OF THE DRAWINGS

Subject matter of the present invention will be described in even greater detail below based on the exemplary figures. All features described and/or illustrated herein can be used alone or combined in different combinations. The features and advantages of various embodiments will become apparent by reading the following detailed description with reference to the attached drawings, which illustrate the following:
FIG. 1 is a schematic structural diagram of an electronic vaporization device according to an embodiment;
FIG. 2 is a schematic structural diagram of an electronic vaporization device according to an embodiment;
FIG. 3 is a schematic structural diagram of an electronic vaporization device according to an embodiment;
FIG. 4 is a schematic structural diagram of an electronic vaporization device according to an embodiment;
FIG. 5 is a schematic structural diagram of an electronic vaporization device according to an embodiment;
FIG. 6 is a schematic structural diagram of a heat-not-burn electronic vaporization device according to another embodiment;
FIG. 7 is a schematic structural diagram of a heat-not-burn electronic vaporization device according to another embodiment; and
FIG. 8 is a flowchart of a method for controlling microwave according to another embodiment.

### DETAILED DESCRIPTION

In order to have a clearer understanding of the technical features, the objectives, and the effects of the present invention, specific implementations of the present invention are now illustrated in detail with reference to the accompanying drawings.

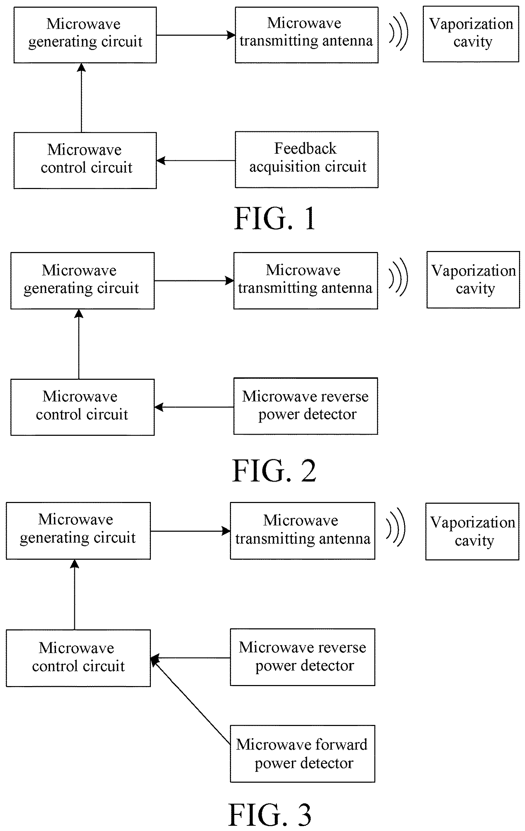

In a preferred embodiment, referring to FIG. 1, the electronic vaporization device in this embodiment is configured to heat and vaporize an aerosol-forming substrate, and the aerosol-forming substrate may be solid tobacco, liquid tobacco oil, and the like. The electronic vaporization device includes a vaporization cavity, a microwave control circuit, a microwave generating circuit, a microwave transmitting antenna, and a feedback acquisition circuit. The vaporization cavity is configured to accommodate an aerosol-forming substrate; and the microwave control circuit is connected to the microwave generating circuit and the feedback acquisition circuit respectively, and the microwave generating circuit is connected to the microwave transmitting antenna.

The working process of the electronic vaporization device is as follows: The microwave control circuit determines a preset-microwave-frequency and controls the microwave generating circuit to generate a microwave according to the preset-microwave-frequency. The microwave transmitting antenna sweeps and transmits the microwave within a preset-microwave-frequency-range, and at least a part of the microwave is gathered in the vaporization cavity to heat the aerosol-forming substrate. It should be noted that, the realization of sweeping and transmitting the microwave by the microwave transmitting antenna within a preset-microwave-frequency-range needs to use the microwave control circuit, and the microwave control circuit sweeps within the preset-microwave-frequency-range to determine the preset-microwave-frequency. For example, the frequency is gradually increased from the minimum frequency of the preset-microwave-frequency-range to the maximum frequency of the preset-microwave-frequency-range, or the frequency is gradually increased from the minimum frequency of the preset-microwave-frequency-range to the maximum frequency of the preset-microwave-frequency-range according to a preset frequency interval, or the frequency is gradually reduced from the maximum frequency of the preset-microwave-frequency-range to the minimum frequency of the preset-microwave-frequency-range, or the frequency is gradually reduced from the maximum frequency of the preset-microwave-frequency-range to the minimum frequency of the preset-microwave-frequency-range according to the preset frequency interval. In another example, the preset-microwave-frequency-range includes at least two preset-microwave-frequency points, and each preset-microwave-frequency point is sequentially transmitted to the microwave generating circuit in a preset order.

Further, after the microwave transmitting antenna transmits the microwave, the feedback acquisition circuit acquires the feedback signal corresponding to the preset-microwave-frequency microwave transmitted by the microwave transmitting antenna, and transmits the feedback signal to the microwave control circuit. The microwave control circuit selects the microwave-transmitting-frequency according to the feedback signal to maintain or modify the preset-microwave-frequency, that is, selects an appropriate microwave-transmitting-frequency to achieve an optimal vaporization state of the aerosol-forming substrate in the vaporization cavity. As an option, the microwave-transmitting-frequency at which the aerosol-forming substrate is absorbed the most is selected as the optimal microwave-transmitting-frequency, and the electronic vaporization device transmits the microwave at this optimal microwave-transmitting-frequency until the next sweeping of the microwave.

The embodiment uses the microwave to directly heat the aerosol-forming substrate, and adjusts the microwave-transmitting-frequency through sweeping, so as to improve the heating efficiency and extend the service life of the device.

In an electronic vaporization device in an embodiment, the feedback signal is a feedback current value, the feedback acquisition circuit is a current acquisition circuit, and the current acquisition circuit takes an induced current value generated by a target object under the action of microwave as the feedback current value.

In an electronic vaporization device in an embodiment, the feedback signal is a feedback voltage value, the feedback acquisition circuit is a voltage acquisition circuit, and the voltage acquisition circuit takes an induced voltage value generated by a target object under the action of microwave as the feedback voltage value.

In an electronic vaporization device in an embodiment, the feedback signal is a feedback capacitance value, the feedback acquisition circuit is a capacitance acquisition circuit, and the capacitance acquisition circuit takes an induced capacitance value generated by a target object under the action of microwave as the feedback capacitance value.

In an electronic vaporization device in an embodiment, the feedback signal is a feedback temperature value, the feedback acquisition circuit is a temperature acquisition circuit, and the temperature acquisition circuit acquires a temperature value generated by a target object under the action of microwave. As an option, the target object may be an aerosol-forming substrate, and the temperature acquisition circuit acquires a temperature value generated by the aerosol-forming substrate under the action of microwave.

In an electronic vaporization device in an embodiment, referring to FIG. 2, the feedback signal is a reverse microwave power, and the feedback acquisition circuit is a microwave reverse power detector. After the microwave is transmitted, not all microwave is absorbed by the aerosol-forming substrate, and some of the unabsorbed microwave is detected by the reverse microwave power to obtain the reverse microwave power. As an option, the microwave transmitting antenna serves as a receiving end that does not absorb the microwave. The microwave reverse power detector detects the reverse microwave power received by the microwave transmitting antenna. The microwave transmitting antenna absorbs a part of the microwave that has not been absorbed by the aerosol-forming substrate, and the microwave reverse power detector detects the power at which the microwave transmitting antenna absorbs the microwave to obtain the reverse microwave power. Further, after the reverse microwave power is obtained, the microwave control circuit selects the optimal microwave-transmitting-frequency according to the reverse microwave power, for example, the microwave control circuit selects the microwave-transmitting-frequency corresponding to the minimum value of the reverse microwave power, or the microwave control circuit selects the microwave-transmitting-frequency in the vicinity of the microwave-transmitting-frequency corresponding to the minimum reverse microwave power.

In an electronic vaporization device in an embodiment, referring to FIG. 3, the electronic vaporization device in this embodiment further includes a microwave forward power detector connected to the microwave control circuit, where the microwave forward power detector is configured to acquire a microwave transmitting power. The microwave control circuit may select the optimal microwave-transmitting-frequency according to the microwave transmitting power and the reverse microwave power, for example, select the optimal microwave-transmitting-frequency according to the ratio of the reverse microwave power to the microwave transmitting power, and select the microwave-transmitting-frequency corresponding to the lowest ratio of the reverse microwave power to the microwave transmitting power.

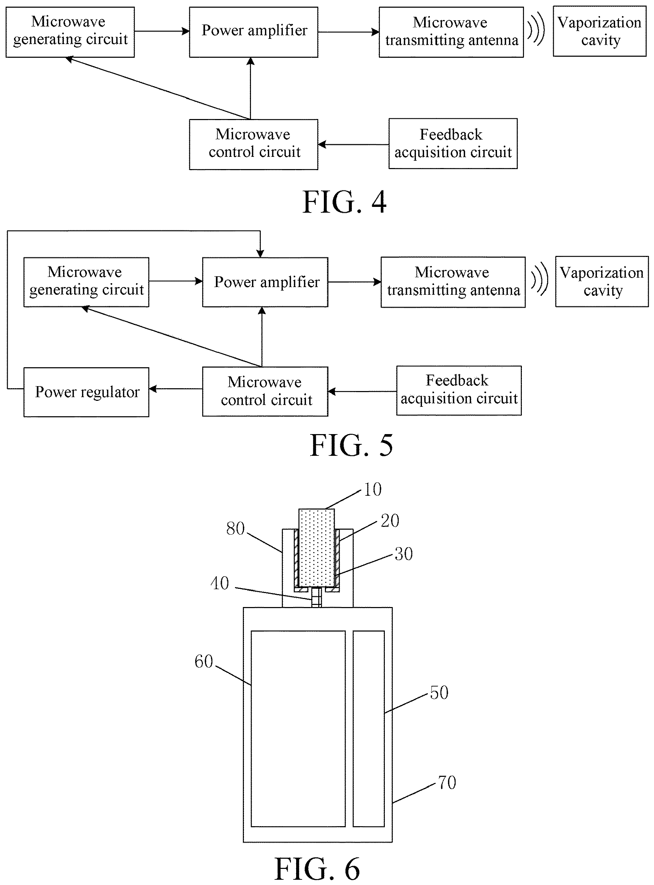

In an electronic vaporization device in an embodiment, referring to FIG. 4, the electronic vaporization device in this embodiment further includes a power amplifier, where an output end of the microwave generating circuit is connected to a first input end of the power amplifier, and an output end of the power amplifier is connected to the microwave transmitting antenna; and the microwave control circuit is connected to the power amplifier, and the microwave control circuit adjusts the power amplifier according to the feedback signal. It can be understood that, the microwave control circuit may control the magnification of the power amplifier.

In an electronic vaporization device in an embodiment, referring to FIG. 5, the electronic vaporization device in this embodiment further includes a power regulator, where the microwave control circuit is connected to an input end of the power regulator, an output end of the power regulator is connected to a second input end of a power amplifier, and the microwave control circuit adjusts the power regulator according to the feedback signal. It can be understood that the power amplifier and the power regulator may be two independent electronic components or may be integrated electronic components, and the integrated electronic components can achieve functions of the power amplifier and the power regulator. As an option, the microwave control circuit simultaneously adjusts the power amplifier and the power regulator according to the feedback signal to achieve a wider range of microwave transmitting power adjustment.

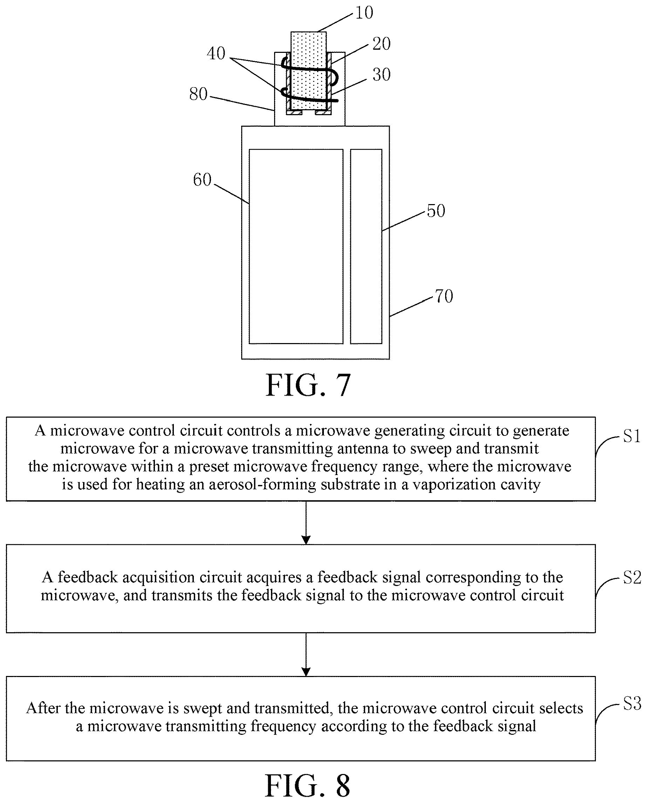

In a preferred embodiment, the electronic vaporization device in this embodiment is a heat-not-burn electronic vaporization device. Referring to FIG. 6 and FIG. 7, in this embodiment, the heat-not-burn electronic vaporization device includes an aerosol-forming substrate 10, a substrate holder 20, a vaporization cavity 30, a microwave transmitting antenna 40, a circuit board 50, a power supply battery 60, and a housing 70, where the substrate holder 20 is configured to place and fix the aerosol-forming substrate 10, the microwave generating circuit, the feedback acquisition circuit, and the microwave control circuit are integrated on the circuit board 50, the power supply battery 60 is configured to supply power to the heat-not-burn electronic vaporization device, and the circuit board 50 and the power supply battery 60 are located inside the housing 70. It can be understood that the substrate holder 20 uses a material that can be penetrated by the microwave to avoid absorbing the microwave. The microwave transmitting antenna 40 has a plurality of mounting positions, and this embodiment is illustrated by example.

In FIG. 6, the microwave transmitting antenna 40 is located at a bottom portion of the vaporization cavity 30 and installed close to the housing 70. The electronic vaporization device further includes a microwave aggregation apparatus 80, and the microwave transmitting antenna 40 is located inside the microwave aggregation apparatus 80. The microwave transmitting antenna 40 transmits the microwave, and the microwave aggregation apparatus 80 aggregates at least a part of the microwave transmitted by the microwave transmitting antenna 40 to the position of the aerosol-forming substrate 10 in the vaporization cavity 30 to heat the aerosol-forming substrate 10. As an option, an inner layer of the microwave aggregation apparatus 80 is a microwave reflective layer. The microwave reflective layer can better aggregate the microwave into the vaporization cavity 30, which improves the microwave utilization rate and improves the heating efficiency. Further, an outer layer of the microwave aggregation apparatus 80 is a microwave shielding layer, and the microwave shielding layer can absorb unused microwave and prevent microwave scattering outside the heat-not-burn electronic vaporization device and causing microwave pollution.

In FIG. 7, the microwave transmitting antenna 40 is wound around the vaporization cavity 30 or the substrate holder 20, and the microwave transmitting antenna 40 transmits the microwave. Most of the microwave transmitted in this manner has been aggregated in the vaporization cavity 30, that is, aggregated on the aerosol-forming substrate 10. Some of the microwave that diverges towards the surrounding area are reflected by the microwave aggregation apparatus 80 and then re-aggregated on the aerosol-forming substrate 10 to heat the aerosol-forming substrate 10.

In a preferred embodiment, referring to FIG. 8, the method for controlling microwave in this embodiment is applied to an electronic vaporization device in the foregoing embodiments. Specifically, the method for controlling microwave includes the following steps:
S1: A microwave control circuit controls a microwave generating circuit to generate a microwave for a microwave transmitting antenna to sweep and transmit the microwave within a preset-microwave-frequency-range, where the microwave is used for heating an aerosol-forming substrate in a vaporization cavity. Specifically, the microwave control circuit determines a preset-microwave-frequency and controls the microwave generating circuit to generate the microwave according to the preset-microwave-frequency. The microwave transmitting antenna sweeps and transmits the microwave within a preset-microwave-frequency-range, and at least a part of the microwave is gathered in the vaporization cavity to heat the aerosol-forming substrate. It should be noted that, the realization of sweeping and transmitting the microwave by the microwave transmitting antenna within a preset-microwave-frequency-range needs to use the microwave control circuit, and the microwave control circuit sweeps within the preset-microwave-frequency-range to determine the preset-microwave-frequency. For example, the frequency is gradually increased from the minimum frequency of the preset-microwave-frequency-range to the maximum frequency of the preset-microwave-frequency-range, or the frequency is gradually increased from the minimum frequency of the preset-microwave-frequency-range to the maximum frequency of the preset-microwave-frequency-range according to a preset frequency interval, or the frequency is gradually reduced from the maximum frequency of the preset-microwave-frequency-range to the minimum frequency of the preset-microwave-frequency-range, or the frequency is gradually reduced from the maximum frequency of the preset-microwave-frequency-range to the minimum frequency of the preset-microwave-frequency-range according to the preset frequency interval. In another example, the preset-microwave-frequency-range includes at least two preset-microwave-frequency points, and each preset-microwave-frequency point is sequentially transmitted to the microwave generating circuit in a preset order.
S2: A feedback acquisition circuit acquires a feedback signal corresponding to the microwave, and transmits the feedback signal to the microwave control circuit. Specifically, after the microwave transmitting antenna transmits the microwave, the feedback acquisition circuit acquires the feedback signal corresponding to the preset-microwave-frequency microwave transmitted by the microwave transmitting antenna, and transmits the feedback signal to the microwave control circuit.
S3: After the microwave is swept and transmitted, the microwave control circuit selects a microwave-transmitting-frequency according to the feedback signal. Specifically, after the microwave transmitting antenna transmits the microwave, the microwave control circuit selects the microwave-transmitting-frequency according to the feedback signal to maintain or modify the preset-microwave-frequency, that is, selects an appropriate microwave-transmitting-frequency to achieve an optimal vaporization state of the aerosol-forming substrate in the vaporization cavity. As an option, the microwave-transmitting-frequency at which the aerosol-forming substrate is absorbed the most is selected as the optimal microwave-transmitting-frequency, and the electronic vaporization device transmits the microwave at this optimal microwave-transmitting-frequency until the next sweeping of the microwave.

The embodiment uses the microwave to directly heat the aerosol-forming substrate, and adjusts the microwave-transmitting-frequency through sweeping, so as to improve the heating efficiency and extend the service life of the device.

In a method for controlling microwave in an embodiment, the selecting, by the microwave control circuit, a microwave-transmitting-frequency according to the feedback signal in step S3 includes: The microwave control circuit selects the microwave-transmitting-frequency and the microwave transmitting power according to the feedback signal, and simultaneously adjusts the microwave-transmitting-frequency and the microwave transmitting power to achieve the optimal vaporization state of the aerosol-forming substrate in the vaporization cavity.

In a method for controlling microwave in an embodiment, the feedback signal in step S2 is a reverse microwave power. After the microwave is transmitted, not all microwave is absorbed by the aerosol-forming substrate, and some of the unabsorbed microwave is detected by the reverse microwave power to obtain the reverse microwave power. Correspondingly, the selecting, by the microwave control circuit, a microwave-transmitting-frequency according to the feedback signal in step S3 includes: the microwave control circuit selects the microwave-transmitting-frequency corresponding to a minimum value of the reverse microwave power.

In a method for controlling microwave in an embodiment, the microwave heats the heat-not-burn electronic vaporization device, which may cause an error in the microwave aggregation apparatus during the production process. The error may cause the preset microwave-transmitting-frequency at the factory to be not the optimal microwave-transmitting-frequency, so it is necessary to calibrate the preset microwave-transmitting-frequency. Before step S1, the method further includes: S101: The microwave control circuit receives a microwave frequency selection instruction, and the microwave frequency selection instruction may be generated by a physical key or a virtual key. Certainly, this step may be completed at the factory or when a user first uses it.

In a method for controlling microwave in an embodiment, because the microwave frequency corresponding to each aerosol-forming substrate is different, that is, the microwave frequency for resonance heating of each aerosol-forming substrate is different, in order to achieve the best heating effect, before step S1, the method further includes: S102: The microwave control circuit receives an aerosol-forming substrate installation completion instruction, that is, the aerosol-forming substrate installation completion instruction is generated after the user newly installs or replaces the aerosol-forming substrate.

In a method for controlling microwave in an embodiment, as the consumption of the aerosol-forming substrate, the position at which the aerosol-forming substrate needs to be heated continuously changes. In order to enable the microwave to accurately heat the aerosol-forming substrate, before step S1, the method further includes: S103: The microwave control circuit receives an inhalation instruction, and the user generates the inhalation instruction each time the inhalation is performed.

In a method for controlling microwave in an embodiment, as the consumption of the aerosol-forming substrate, the position at which the aerosol-forming substrate needs to be heated continuously changes. In order to enable the microwave to accurately heat the aerosol-forming substrate, before step S1, the method further includes: S104: The microwave control circuit presets an inhalation time every interval.

It should be noted that the embodiments in this specification are all described in a progressive manner. Description of each of the embodiments focuses on differences from other embodiments, and reference may be made to each other for the same or similar parts among the embodiments. The apparatus embodiments are substantially similar to the method embodiments and therefore are only briefly described, and reference may be made to the method embodiments for the associated part.

Persons skilled in the art may further realize that, in combination with the embodiments herein, units and algorithm, steps of each example described can be implemented with electronic hardware, computer software, or the combination thereof. In order to clearly describe the interchangeability between the hardware and the software, compositions and steps of each example have been generally described according to functions in the foregoing descriptions. Whether the functions are performed by hardware or software depends on particular applications and design constraint conditions of the technical solutions. A person skilled in the art may use different methods to implement the described functions for each particular application, but it should not be considered that the implementation goes beyond the scope of the present invention.

In combination with the embodiments herein, steps of the method or algorithm described may be directly implemented using hardware, a software module executed by a processor, or the combination thereof. The software module may be placed in a random access memory (RAM), a memory, a read-only memory (ROM), an electrically programmable ROM (EPROM), an electrically erasable programmable ROM (EEPROM), a register, a hard disk, a removable magnetic disk, a CD-ROM, or any storage medium of other forms well-known in the technical field.

While the invention has been illustrated and described in detail in the drawings and foregoing description, such illustration and description are to be considered illustrative or exemplary and not restrictive. It will be understood that changes and modifications may be made by those of ordinary skill within the scope of the following claims. In particular, the present invention covers further embodiments with any combination of features from different embodiments described above and below. Additionally, statements made herein characterizing the invention refer to an embodiment of the invention and not necessarily all embodiments.

## Claims

1. An electronic vaporization device for heating and vaporizing an aerosol-forming substrate, comprising:
a vaporization cavity configured to accommodate the aerosol-forming substrate;
a microwave generating circuit configured to generate a microwave according to a preset-microwave-frequency;
a microwave transmitting antenna connected to the microwave generating circuit, and configured to sweep and transmit a microwave within a preset-microwave-frequency-range and transmit the microwave to the vaporization cavity to heat the aerosol-forming substrate;
a feedback acquisition circuit configured to acquire a feedback signal corresponding to the microwave of the preset-microwave-frequency that is transmitted by the microwave transmitting antenna; and
a microwave control circuit connected to the microwave generating circuit and the feedback acquisition circuit respectively, and configured to determine the preset-microwave-frequency, control the microwave generating circuit to generate the microwave according to the preset-microwave-frequency, and select a preset-microwave-frequency according to the feedback signal to maintain or modify the preset-microwave-frequency.

2. The electronic vaporization device of claim 1, wherein the feedback signal is a feedback current value, and the feedback acquisition circuit is a current acquisition circuit, or
wherein the feedback signal is a feedback voltage value, and the feedback acquisition circuit is a voltage acquisition circuit, or
wherein the feedback signal is a feedback capacitance value, and the feedback acquisition circuit is a capacitance acquisition circuit, or
wherein the feedback signal is a feedback temperature value, and the feedback acquisition circuit is a temperature acquisition circuit.

3. The electronic vaporization device of claim 1, wherein the feedback signal is a reverse microwave power, and the feedback acquisition circuit is a microwave reverse power detector.

4. The electronic vaporization device of claim 3, wherein the microwave reverse power detector is configured to detect a reverse microwave power received by the microwave transmitting antenna.

5. The electronic vaporization device of claim 1, further comprising:
a microwave forward power detector connected to the microwave control circuit and configured to acquire a microwave transmitting power.

6. The electronic vaporization device of claim 1, further comprising:
a power amplifier,
wherein an output end of the microwave generating circuit is connected to a first input end of the power amplifier,
wherein an output end of the power amplifier is connected to the microwave transmitting antenna, and
wherein the microwave control circuit is connected to the power amplifier and configured to adjust the power amplifier according to the feedback signal.

7. The electronic vaporization device of claim 6, further comprising:
a power regulator,
wherein the microwave control circuit is connected to an input end of the power regulator,
wherein an output end of the power regulator is connected to a second input end of the power amplifier, and
wherein the microwave control circuit is configured to adjust the power regulator according to the feedback signal.

8. A heat-not-burn electronic vaporization device, comprising:
a vaporization cavity configured to accommodate an aerosol-forming substrate;
a circuit board comprising a microwave generating circuit, a feedback acquisition circuit, and a microwave control circuit connected to the microwave generating circuit and the feedback acquisition circuit respectively, and the microwave generating circuit being configured to generate a microwave according to a preset-microwave-frequency;
a microwave transmitting antenna connected to the microwave generating circuit and configured to sweep and transmit the microwave within a preset-microwave-frequency-range and transmit the microwave to the vaporization cavity to heat the aerosol-forming substrate,
wherein the feedback acquisition circuit is configured to acquire a feedback signal corresponding to the microwave of the preset-microwave-frequency that is transmitted by the microwave transmitting antenna,
wherein the microwave control circuit is configured to determine the preset-microwave-frequency, and control the microwave generating circuit to generate the microwave according to the preset-microwave-frequency, and
wherein the microwave control circuit is configured to select a microwave-transmitting-frequency according to the feedback signal to maintain or modify the preset-microwave-frequency.

9. The heat-not-burn electronic vaporization device of claim 8, wherein the feedback signal is a feedback current value, and the feedback acquisition circuit is a current acquisition circuit, or
wherein the feedback signal is a feedback voltage value, and the feedback acquisition circuit is a voltage acquisition circuit, or
wherein the feedback signal is a feedback capacitance value, and the feedback acquisition circuit is a capacitance acquisition circuit, or
wherein the feedback signal is a feedback temperature value, and the feedback acquisition circuit is a temperature acquisition circuit.

10. The heat-not-burn electronic vaporization device of claim 8, wherein the feedback signal is a reverse microwave power, and the feedback acquisition circuit is a microwave reverse power detector.

11. The heat-not-burn electronic vaporization device of claim 10, wherein the microwave reverse power detector is configured to detect a reverse microwave power received by the microwave transmitting antenna.

12. The heat-not-burn electronic vaporization device of claim 8, further comprising:
a microwave forward power detector connected to the microwave control circuit and configured to acquire a microwave transmitting power.

13. The heat-not-burn electronic vaporization device of claim 8, further comprising:
a power amplifier,
wherein an output end of the microwave generating circuit is connected to a first input end of the power amplifier,
wherein an output end of the power amplifier is connected to the microwave transmitting antenna,
wherein the microwave control circuit is connected to the power amplifier, and
wherein the microwave control circuit is configured to adjust the power amplifier according to the feedback signal.

14. The heat-not-burn electronic vaporization device of claim 8, further comprising:
a power regulator,
wherein the microwave control circuit is connected to an input end of the power regulator,
wherein an output end of the power regulator is connected to a second input end of a power amplifier, and
wherein the microwave control circuit is configured to adjust the power regulator according to the feedback signal.

15. The heat-not-burn electronic vaporization device of claim 8, further comprising:
a microwave aggregation apparatus,
wherein the microwave transmitting antenna is located in the microwave aggregation apparatus, and
wherein the microwave aggregation apparatus is configured to aggregate at least a part of the microwave transmitted by the microwave transmitting antenna to the vaporization cavity.

16. The heat-not-burn electronic vaporization device of claim 15, wherein an inner layer of the microwave aggregation apparatus is a microwave reflective layer.

17. The heat-not-burn electronic vaporization device of claim 16, wherein an outer layer of the microwave aggregation apparatus is a microwave shielding layer.

18. A method for controlling a microwave, applied to the electronic vaporization device of any of claims 1 to 17, comprising:
S 1: controlling, by a microwave control circuit, a microwave generating circuit to generate a microwave for a microwave transmitting antenna to sweep and transmit the microwave within a preset-microwave-frequency-range, the microwave being used to heat an aerosol-forming substrate in a vaporization cavity;
S2: acquiring, by a feedback acquisition circuit, a feedback signal corresponding to the microwave, and transmitting the feedback signal to the microwave control circuit; and
S3: selecting, after the microwave is swept and transmitted, by the microwave control circuit, a microwave-transmitting-frequency according to the feedback signal.

19. The method for controlling the microwave of claim 18, wherein, the selecting, by the microwave control circuit, a microwave-transmitting-frequency according to the feedback signal in step S3 comprises: selecting, by the microwave control circuit, the microwave-transmitting-frequency and a microwave transmitting power according to the feedback signal.

20. The method for controlling the microwave of claim 18, wherein the feedback signal in step S2 is a reverse microwave power; and
wherein, the selecting, by the microwave control circuit, a microwave-transmitting-frequency according to the feedback signal in step S3 comprises: selecting, by the microwave control circuit, the microwave-transmitting-frequency corresponding to the minimum value of the reverse microwave power.

21. The method for controlling the microwave of claim 18, wherein, before step S1, the method further comprises:
S101: receiving, by the microwave control circuit, a microwave frequency selection instruction; or
S102: receiving, by the microwave control circuit, an aerosol-forming substrate installation completion instruction; or
S103: receiving, by the microwave control circuit, an inhalation instruction; or
S104: presetting, by the microwave control circuit, an inhalation time every interval.
